# EUROPÄISCHE PATENTSCHRIFT

(11) **EP 3 413 344 B1**
(45) Veröffentlichungstag und Bekanntmachung des Hinweises auf die Patenterteilung: **29.12.2021**
(21) Anmeldenummer: 18171767.9
(22) Anmeldetag: 11.05.2018
(51) Int. Cl.: H01L 23/495, H01L 23/488, H01L 23/34, H01L 25/07

(54) **VERBINDUNGSELEMENT IN FORM EINES MULTIFUNKTIONSBÜGELS SOWIE SCHALTUNGSANORDNUNG MIT DIESEM VERBINDUNGSELEMENT**
CONNECTING ELEMENT IN THE FORM OF A MULTIFUNCTIONAL CLIP AND CIRCUIT ARRANGEMENT WITH SAID CONNECTING ELEMENT
ÉLÉMENT DE CONNEXION SOUS FORME D'UNE PINCE MULTIFONCTIONNELLE AINSI QU'AGENCEMENT DE CIRCUIT COMPRENANT CET ÉLÉMENT DE CONNEXION

(30) Priorität: 15.05.2017 DE 102017110504
(43) Veröffentlichungstag der Anmeldung: 12.12.2018
(73) Patentinhaber: HE System Electronic GmbH, 90587 Veitsbronn (DE)
(72) Erfinder: Münch, Dagmar, 60327 Frankfurt (DE); Reulein, Timo, 90427 Nürnberg (DE); Kastner, Jürgen, 91126 Rednitzhembach (DE); Fuchs, Martin, 90451 Nürnberg (DE); Römisch, Maximilian, 91058 Erlangen (DE); Pröll, Peter, 91608 Geslau (DE)
(74) Vertreter: Schröer, Gernot H.

(56) Entgegenhaltungen:
- DE-A1-102006 051 454
- DE-A1-102013 215 124
- DE-A1-102015 200 480
- FR-A7- 2 295 686
- US-A1- 2013 307 129
- US-A1- 2014 217 569
- US-A1- 2015 340 350

## Beschreibung

Die Erfindung betrifft eine Schaltungsanordnung.

Bestehende Schaltungsanordnungen haben den Nachteil, dass deren Funktionalität zumindest relativ stark begrenzt ist.

US 2013/0307129 A1 beschreibt ein Verdrahtungselement, das einen ersten Schenkelabschnitt, einen zweiten Schenkelabschnitt, einen dritten Schenkelabschnitt, eine erste Verbindungswand und eine zweite Verbindungswand umfasst. Der erste Schenkelabschnitt ist elektrisch mit einem ersten leitenden Abschnitt verbunden. Der zweite Schenkelabschnitt ist elektrisch mit einem zweiten leitenden Abschnitt verbunden. Der dritte Schenkelabschnitt ist elektrisch mit einem dritten leitenden Abschnitt verbunden. Die erste Verbindungswand verbindet den ersten Schenkelabschnitt und den zweiten Schenkelabschnitt. Die zweite Verbindungswand verbindet den zweiten Schenkelabschnitt und den dritten Schenkelabschnitt. Der erste Beinabschnitt, der zweite Beinabschnitt und der dritte Beinabschnitt sind nicht linear angeordnet.

DE 10 2015 200 480 A1 betrifft eine Kontaktanordnung zumindest eines Leistungshalbleiters mit einem Schaltungsträger einer Schaltung. Der zumindest eine Leistungshalbleiter weist dabei eine Oberseite und eine Unterseite auf und ist mit der Unterseite mit dem Schaltungsträger verbunden. Ferner ist auf der Oberseite des zumindest einen Leistungshalbleiters mittelbar oder unmittelbar ein elektrisches und/oder elektronisches Bauelement angeordnet. Das elektrische und/oder elektronische Bauelement ist ein Temperatursensor, welcher ausgebildet ist, eine Temperatur des Leistungshalbleiters zu ermitteln und ein Temperatursignal bereitzustellen, welches als Regelgröße für einen maximalen Strom in dem zumindest einem Leistungshalbleiter dient. Zwischen dem Temperatursensor und dem Leistungshalbleiter ist ein metallischer Clip. Der metallische Clip ist mit einem Verbindungselement, das ein Bondbändchen sein kann, kontaktiert.

Aufgabe der Erfindung ist es daher, eine neue Schaltungsanordnung bereitzustellen, bei der bevorzugt die Funktionalität in geringerem Umfang begrenzt ist und/oder erweitert ist.

Diese Aufgabe wird gelöst durch eine Schaltungsanordnung nach Anspruch 1. Vorteilhafte Weiterbildungen ergeben sich insbesondere aus den jeweiligen abhängigen Ansprüchen.

Gemäß Anspruch 1 betrifft die Erfindung eine Schaltungsanordnung nach Anspruch 1. Unter der Formulierung "elektrisch und thermisch leitende Verbindung bzw.

Anbindung" ist zu verstehen, dass die jeweiligen Bereiche oder Flächen eine elektrisch und thermisch leitende Verbindung bzw. Anbindung aufweisen.

Das im Anspruch 1 definierte Bondelement dient somit nicht nur zur Ausbildung/Herstellung einer elektrisch und thermisch leitenden Verbindung, mechanischen Kopplung und Fixierung eines ersten Bauelements sowie zur elektrisch und thermisch leitenden Fixierung, Anbindung, Anbringung und Kontaktierung des Verbindungselements an ein zweites Bauelement, sondern auch zur elektrisch und thermisch leitenden Anbringung, Anbindung und Fixierung eines dritten Bauelements, womit die Funktionalität des Bondelements in geringerem Umfang begrenzt ist und/oder in vorteilhafter Weise erweitert wird.

Dies kann insbesondere bedeuten, dass mittels des Bondelements nicht nur eine Funktion oder ein einziges Bauelement, sondern zumindest zwei Funktionen oder Bauelemente oder auch zumindest eine Funktion und ein Bauelement implementiert bzw. realisiert werden. Beim Bondelement ist somit bevorzugt die Funktionalität gegenüber herkömmlichen Verbindungselementen in geringerem Umfang begrenzt und/oder erweitert, weil statt der Implementierung nur einer einzigen Funktion oder eines einzigen Bauelements mehrere Funktionen, insbesondere Schaltungsfunktionen, mehrere Bauelemente oder zumindest eine Funktion und ein Bauelement implementiert oder realisiert werden können oder implementiert bzw. realisiert sind.

Das dritte Bauelement ist ein zweiter Schaltungsträger. Auf dem dritten Bauelement ist ein Sensor angeordnet, der beispielsweise ein Stromsensor oder ein Temperatursensor sein kann.

Die erste Verbindungsfläche ist auf der Unterseite des Bondelements angeordnet, die zweite Verbindungsfläche ist auf der Unterseite des Bondelements angeordnet und die dritte Verbindungsfläche ist auf der Oberseite des Bondelements angeordnet.

Insbesondere können die erste und die zweite Verbindungsfläche in einer ersten Ebene und die dritte Verbindungsfläche in einer zweiten Ebene angeordnet sein, wobei die erste Ebene von der zweiten Ebene verschieden ist, insbesondere zu dieser parallel oder mit einem Winkel angeordnet ist, wobei zwischen der ersten und der dritten Verbindungsfläche und/oder zwischen der zweiten und der dritten Verbindungsfläche ein Übergangsbereich angeordnet ist, der insbesondere stufenartig und/oder s-förmig verläuft. Die erste und die zweite Verbindungsfläche können jedoch auch, in einer weiteren bevorzugten Ausführungsform, in unterschiedlichen Ebenen, insbesondere parallel oder in einem beliebigen Winkel zueinander, angeordnet sein.

Unter der Formulierung "zu dieser parallel oder mit einem Winkel" ist insbesondere zu verstehen, dass die jeweiligen Bereiche oder Flächen zueinander parallel sein können oder in einem beliebigen Winkel zueinander stehen können. Dies bedeutet insbesondere, dass die jeweiligen Bereiche oder Flächen zueinander zum Beispiel einen Winkel von 0°, von unter 10°, von unter 20°, von unter 30°, von unter 40° oder einen beliebigen anderen Winkel haben können.

Insbesondere kann das Bondelement aus Metall oder aus einer Metallverbindung bestehen und/oder einstückig oder zweistückig, ausgebildet sein. In einer Ausführungsform ist das Bondelement aus einem flachen, insbesondere rechteckigen oder länglichen Metallteil hergestellt und bevorzugt mit zwei oder wenigstens zwei Krümmungsbereichen versehen. Das Metallteil kann an den Stirnseiten verschmälert sein.

Das Bondelement ist ein Multifunktionsbügel, zur Kontaktierung wenigstens eines Halbleiters, zum Beispiel eines Transistors und/oder Leistungstransistors und/oder MOSFETs.

Insbesondere können die erste Kontaktierungsfläche in einer dritten Ebene und die zweite Kontaktierungsfläche in einer vierten Ebene angeordnet sein, wobei die dritte Ebene von der vierten Ebene verschieden ist, insbesondere zu dieser parallel oder mit einem Winkel angeordnet ist oder wobei die dritte Ebene mit der vierten Ebene identisch ist.

In einer Ausführungsform ist zwischen der ersten Kontaktierungsfläche und der zweiten Kontaktierungsfläche ein Ubergangsbereich angeordnet, wobei der Übergangsbereich insbesondere gerade, L-förmig, stufenartig und/oder s-förmig verläuft.

Vorzugsweise können das erste und das zweite Kontaktierungselement aus Metall oder aus einer Metallverbindung bestehen und/oder einstückig oder zweistückig ausgebildet sein.

In einer Ausführungsform sind das erste und das zweite Kontaktierungselement aus einem flachen, insbesondere rechteckigen Metallteil hergestellt und mit einem oder zwei Krümmungsbereichen versehen.

Insbesondere können das erste und das zweite Kontaktierungselement horizontal und/oder vertikal verlaufen und/oder parallel oder senkrecht zum dritten Verbindungsbereich ausgebildet sein.

In einer Ausführungsform umfasst die Schaltungsanordnung wenigstens eines, wenigstens zwei oder mehrere der folgenden Bauelemente und/oder bildet dieses oder diese aus:
▪ Anschlusselement für eine Ansteuerplatine,
▪ Temperaturmesselement,
▪ Widerstand,
▪ Kelvin-Anschluss des Mosfets,
▪ Kondensator,
▪ Gatetreiber,
▪ Stromsensor,
▪ Verstärker,
▪ Ladungspumpe,
▪ Dioden,
▪ Spule sowie
▪ Anschlusselement für Messpunkte.

Vorzugsweise umfasst die Schaltungsanordnung ein Anschlusselement für eine Ansteuerplatine, ein Temperaturmesselement, Widerstand, Kelvin-Anschluss des Mosfets, Kondensator, Gatetreiber, Stromsensor, Verstärker, Ladungspumpe, eine Diode, Spule und/oder ein Anschlusselement für Messpunkte. Insbesondere kann die Schaltungsanordnung zwei oder mehr der genannten Bauelemente ausbilden und somit bevorzugt mehrere Bauelemente innerhalb oder mittels des Bondelements kombinieren.

In einer Ausführungsform ist die Schaltungsanordnung wenigstens zu einem oder mehreren der folgenden Zwecke oder Funktionen vorgesehen:
▪ Anschluss einer Ansteuerplatine,
▪ Anschluss eines Bauelements,
▪ Temperaturmessung,
▪ Bereitstellen eines Widerstands,
▪ Kelvin-Anschluss eines Mosfets,
▪ Bereitstellen einer Kapazität,
▪ Gatetreiber,
▪ Stromsensor,
▪ Verstärkung,
▪ Ladungspumpe,
▪ Sperrung der intrinsischen Diode eines Mosfets,
▪ Bereitstellung einer Induktivität sowie
▪ Anschluss von Messpunkten.

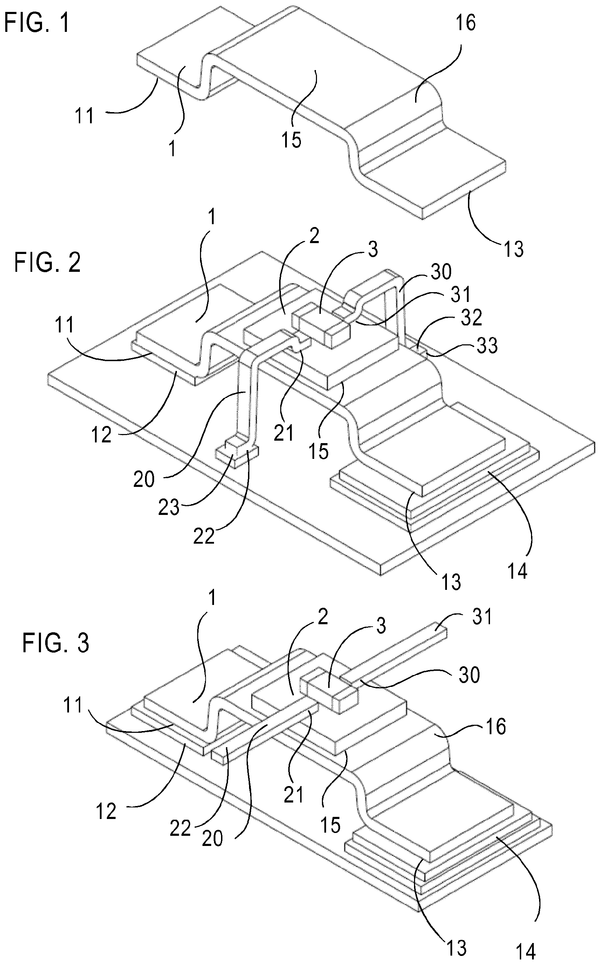

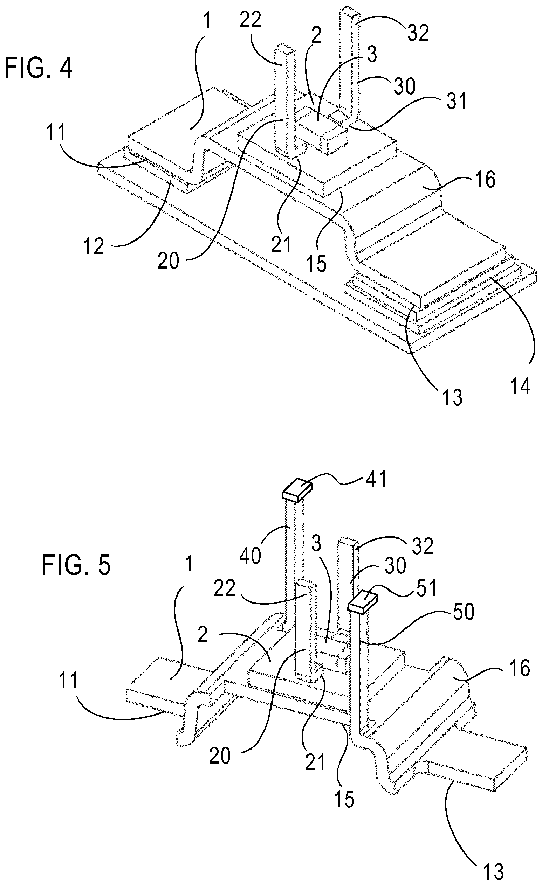

Die Erfindung wird im Folgenden durch Figuren näher erläutert, wobei
FIG. 1 ein Bondelement (nachfolgend auch ein Verbindungselement genannt),
FIG. 2 ein erstes Beispiel einer Schaltungsanordnung,
FIG. 3 ein zweites Beispiel einer Schaltungsanordnung,
FIG. 4 ein drittes Beispiel einer Schaltungsanordnung,
FIG. 5 ein viertes Beispiel einer Schaltungsanordnung,
FIG. 6 ein Bondelement (nachfolgend auch ein Verbindungselement genannt) und
FIG. 7 ein weiteres Bondelement (nachfolgend auch ein Verbindungselement genannt)
zeigt. Die Figur 5 zeigt einen Teil einer Schaltungsanordnung gemäß einer Ausführungsform der beanspruchten Erfindung. Die Figuren 1-4, 6 und 7 entsprechen nicht der beanspruchten Erfindung, zeigen aber einige Aspekte davon und können daher zum weiteren Verständnis der Erfindung herangezogen werden.

FIG. 1 bis FIG. 7 zeigen Bondelemente, nachfolgend auch Verbindungselemente benannt.

Das Verbindungselement 1 ist ein Multifunktionsbügel, zur Kontaktierung wenigstens eines Halbleiters.

Die Verbindungselemente 1 in FIG. 1 bis FIG. 7 umfassen einen ersten Verbindungsbereich 11, der als erste Verbindungsfläche ausgebildet ist, zur Ausbildung oder Herstellung einer elektrisch und thermisch leitenden Verbindung, mechanischen Kopplung und Fixierung eines ersten Bauelements 12 und des Verbindungselements 1 bzw. mit dem Verbindungselement 1. Über den ersten Verbindungsbereich 11 ist das Verbindungselement 1 mit dem ersten Bauelement 12 verbunden oder verbindbar.
Das erste Bauelement 12 ist ein Leistungshalbleiter-Bauelement.

Die Verbindungselemente 1 in FIG. 1 bis FIG. 7 umfassen einen zweiten Verbindungsbereich 13, der als zweite Verbindungsfläche ausgebildet ist, zur elektrisch und thermisch leitenden Fixierung, Anbindung und Kontaktierung des Verbindungselements 1 an ein zweites Bauelement 14. Über den zweiten Verbindungsbereich 13 ist das Verbindungselement 1 mit dem zweiten Bauelement 14 verbunden oder verbindbar.

Gemäß der beanspruchten Erfindung ist das zweite Bauelement 14 insbesondere ein erster Schaltungsträger.

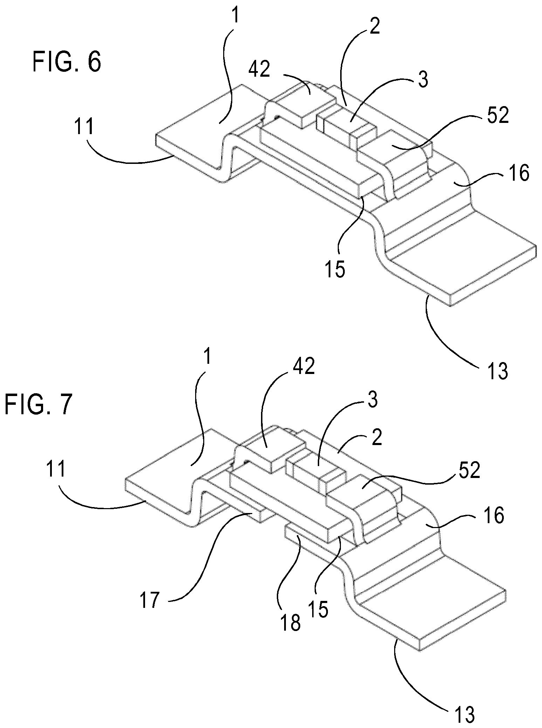

Die Verbindungselemente 1 in FIG. 6 und FIG. 7 umfassen einen dritten Verbindungsbereich 15, der als dritte Verbindungsfläche ausgebildet ist, zur elektrisch und thermisch leitenden Anbindung und Fixierung eines dritten Bauelements 2 an das Verbindungselement 1. Über den dritten Verbindungsbereich 15 ist das Verbindungselement 1 mit dem dritten Bauelement 2 verbunden.

Die Verbindungselemente 1 in FIG. 2 bis FIG. 5 umfassen einen dritten Verbindungsbereich 15, der als dritte Verbindungsfläche ausgebildet ist, zur elektrisch und thermisch leitenden Anbindung und Fixierung eines dritten Bauelements 2 und von zwei Kontaktierungselementen 20 und 30 an das Verbindungselement 1. Über den dritten Verbindungsbereich 15 ist das Verbindungselement 1 mit dem dritten Bauelement 2 verbunden.

Der erste Verbindungsbereich 11 ist auf der Unterseite des Verbindungselements 1 angeordnet, der zweite Verbindungsbereich 13 ist auf der Unterseite des Verbindungselements 1 angeordnet und der dritte Verbindungsbereich 15 ist auf der Oberseite des Verbindungselements 1 angeordnet.

Gemäß der beanspruchten Erfindung ist das dritte Bauelement 2 ein zweiter Schaltungsträger.

Auf dem zweiten Bauelement 2 ist ein Sensor 3 angeordnet, der beispielsweise ein Stromsensor oder ein Temperatursensor sein kann.

Das Verbindungselement 1 in FIG. 2 bis FIG. 4 ist auf einem Schaltungsträger fixiert, der aus Keramik ausgebildet sein kann. Das Verbindungselement 1 hat vorzugsweise eine Länge zwischen 10 mm und 15 mm.

Das Verbindungselement 1 in FIG. 5 umfasst zudem einen vierten Verbindungsbereich 40, der als vierte Verbindungsfläche ausgebildet ist, zur elektrisch und thermisch leitenden Anbindung und Fixierung eines sechsten Bauelements 41 an das Verbindungselement 1. Über den vierten Verbindungsbereich 40 ist das Verbindungselement 1 mit dem sechsten Bauelement 41 verbunden oder verbindbar. Der Verbindungsbereich 40 erstreckt sich senkrecht nach oben und ist aus dem Verbindungselement 1 ausgeschnitten.

Das sechste Bauelement 41 kann insbesondere ein zweiter Schaltungsträger sein.

Die Verbindungselemente 1 in FIG. 6 bis FIG. 7 umfassen zudem einen vierten Verbindungsbereich 42, der als vierte Verbindungsfläche ausgebildet ist, zur elektrisch und thermisch leitenden Anbindung und Fixierung des dritten Bauelements 2 an das Verbindungselement 1. Über den vierten Verbindungsbereich 42 ist das Verbindungselement 1 mit dem dritten Bauelement 2 verbunden oder verbindbar. Der Verbindungsbereich 42 erstreckt sich waagerecht.

Das Verbindungselement in FIG. 5 umfasst auch einen fünften Verbindungsbereich 50, der als fünfte Verbindungsfläche ausgebildet ist, zur elektrisch und thermisch leitenden Anbindung und Fixierung eines siebten Bauelements 51 an das Verbindungselement 1. Über den fünften Verbindungsbereich 50 ist das Verbindungselement 1 mit dem siebten Bauelement 51 verbunden oder verbindbar. Der Verbindungsbereich 50 erstreckt sich senkrecht nach oben und ist aus dem Verbindungselement 1 ausgeschnitten.

Das siebte Bauelement 51 kann insbesondere ein zweiter Schaltungsträger sein.

Die Verbindungselemente in FIG. 6 bis FIG. 7 umfassen auch einen fünften Verbindungsbereich 52, der als fünfte Verbindungsfläche ausgebildet ist, zur elektrisch und thermisch leitenden Anbindung und Fixierung des dritten Bauelements 2 an das Verbindungselement 1. Über den fünften Verbindungsbereich 52 ist das Verbindungselement 1 mit dem dritten Bauelement 2 verbunden oder verbindbar. Der Verbindungsbereich 52 erstreckt sich waagerecht.

In FIG. 1 bis FIG. 7 sind zumindest der erste Verbindungsbereich 11, der zweite Verbindungsbereich 13 und der dritte Verbindungsbereich 15 elektrisch und thermisch leitend verbunden. Das Verbindungselement 1 ist zumindest teilweise elektrisch leitend ausgebildet.

Der erste und zweite Verbindungsbereich in FIG. 1 bis FIG. 7 ist in einer ersten Ebene und der dritte Verbindungsbereich in einer zweiten Ebene angeordnet. Die erste Ebene ist von der zweiten Ebene verschieden, insbesondere zu dieser parallel, kann aber auch mit einem Winkel zu dieser angeordnet sein.

Der erste und der zweite Verbindungsbereich können jedoch auch, in einer weiteren bevorzugten Ausführungsform, in unterschiedlichen Ebenen, insbesondere in einem beliebigen Winkel zueinander, angeordnet sein.

Zwischen dem ersten und dem dritten Verbindungsbereich und zwischen dem zweiten und dritten Verbindungsbereich ist ein Übergangsbereich 16 angeordnet, der insbesondere stufenartig und/oder s-förmig verläuft.

Das Verbindungselement 1 besteht aus Metall oder aus einer Metallverbindung. Das Verbindungselement 1 in FIG. 1 bis FIG. 6 ist einstückig ausgebildet. Das Verbindungselement 1 in FIG. 7 ist zweistückig ausgebildet, wobei die Stücke 17, 18 beabstandet sind und keine elektrisch und thermisch leitende Verbindung ausbilden.

Das Verbindungselement ist 1 aus einem flachen, insbesondere rechteckigen und/oder oder länglichen Metallteil hergestellt und mit zwei Krümmungsbereichen versehen. An den Stirnseiten kann das Metallteil verschmälert sein, wie aus FIG. 5 ersichtlich.

Das Verbindungselement 1 ist ein Multifunktionsbügel.

Die Anordnungen in FIG. 2 bis 5 sind Schaltungsanordnungen und umfassen ein oder wenigstens ein Verbindungselement 1.

Die Schaltungsanordnungen in FIG. 2 bis FIG. 5 umfassen ein erstes Kontaktierungselement 20 als ersten Kontaktbügel, zur elektrisch und thermisch leitenden Anbindung des dritten Bauelements 2 an ein viertes Bauelement 23. Über das erste Kontaktierungselement 20 ist das dritte Bauelement 2 mit dem vierten Bauelement 23 verbunden oder verbindbar.

Das erste Kontaktierungselement 20 umfasst eine erste Kontaktierungsfläche 21 zur elektrisch und thermisch leitenden Anbindung des dritten Bauelements 2 an das Kontaktierungselement 20. Über die erste Kontaktierungsfläche 21 ist das Kontaktierungselement 20 mit dem dritten Bauelement 2 verbunden oder verbindbar.

Das erste Kontaktierungselement 20 umfasst weiterhin eine zweite Kontaktierungsfläche 22 zur elektrisch und thermisch leitenden Anbindung eines vierten Bauelements 23 an das Kontaktierungselement 20. Über die zweite Kontaktierungsfläche 22 ist das Kontaktierungselement 20 mit dem vierten Bauelement 23 verbunden oder verbindbar.

Die Schaltungsanordnungen in FIG. 2 bis FIG. 5 umfassen ein zweites Kontaktierungselement 30 als zweiten Kontaktbügel, zur elektrisch und thermisch leitenden Anbindung des dritten Bauelements 2 an ein fünftes Bauelement 33. Über das zweite Kontaktierungselement 30 ist das dritte Bauelement 2 mit dem fünften Bauelement 33 verbunden oder verbindbar.

Das zweite Kontaktierungselement 30 umfasst eine erste Kontaktierungsfläche 31 zur elektrisch und thermisch leitenden Anbindung des dritten Bauelements 33 an das Kontaktierungselement 30. Über die erste Kontaktierungsfläche 31 ist das Kontaktierungselement 30 mit dem dritten Bauelement 2 verbunden oder verbindbar.

Das zweite Kontaktierungselement 30 umfasst zudem feine zweite Kontaktierungsfläche 32 zur elektrisch und thermisch leitenden Anbindung des fünften Bauelements 33 an das Kontaktierungselement 30. Über die zweite Kontaktierungsfläche 32 ist das Kontaktierungselement 30 mit dem fünften Bauelement 33 verbunden oder verbindbar.

Die erste Kontaktierungsfläche 21/31 ist in einer dritten Ebene und die zweite Kontaktierungsfläche 22/32 in einer vierten Ebene angeordnet. Die dritte Ebene ist in FIG. 2, FIG. 4 und FIG. 5 von der vierten Ebene verschieden und zu dieser parallel, kann aber auch mit einem Winkel zu dieser angeordnet sein. Die dritte Ebene in FIG. 3 ist mit der vierten Ebene identisch.

Zwischen der ersten Kontaktierungsfläche 21/31 und der zweiten Kontaktierungsfläche 22/32 ist ein Ubergangsbereich angeordnet. Der Ubergangsbereich verläuft in FIG. 2 stufenartig und/oder s-förmig, in FIG. 3 gerade und in FIG. 4 und FIG. 5 L-förmig.

Das Kontaktierungselement 20 und das Kontaktierungselement 30 bestehen aus Metall oder aus einer Metallverbindung. Das Kontaktierungselement 20 und das Kontaktierungselement 30 in FIG. 2 bis FIG. 5 sind jeweils einstückig ausgebildet. Alternativ ist auch eine zweistückige Ausbildung möglich.

Das Kontaktierungselement 20 und das Kontaktierungselement 30 sind jeweils aus einem flachen, insbesondere rechteckigen Metallteil hergestellt. Das Kontaktierungselement 20 und das Kontaktierungselement 30 in FIG. 2 sind mit zwei Krümmungsbereichen versehen. Das Kontaktierungselement 20 und das Kontaktierungselement 30 in FIG. 3 sind mit keinem Krümmungsbereich versehen. Das Kontaktierungselement 20 und das Kontaktierungselement 30 in FIG. 4 und FIG. 5 sind mit einem Krümmungsbereich versehen.

Das Kontaktierungselement 20 und das Kontaktierungselement 30 verlaufen in FIG. 2 horizontal und vertikal sowie parallel und senkrecht zum dritten Verbindungsbereich 15. Das Kontaktierungselement 20 und das Kontaktierungselement 30 verlaufen in FIG. 3 horizontal und parallel zum dritten Verbindungsbereich 15. Das Kontaktierungselement 20 und das Kontaktierungselement 30 verlaufen in FIG. 4 und FIG. 5 horizontal und vertikal sowie parallel und senkrecht zum dritten Verbindungsbereich 15.

Die Schaltungsanordnung implementiert oder realisiert vorzugsweise mehrere Funktionen, insbesondere mehrere Schaltungsfunktionen und/oder mehrere Bauelemente.

Die Schaltungsanordnung umfasst, realisiert oder ist wenigstens eines oder eine Kombination von mehreren der folgenden Bauelemente:
▪ Anschlusselement für eine Ansteuerplatine,
▪ Temperaturmesselement,
▪ Widerstand,
▪ Kelvin-Anschluss des Mosfets,
▪ Kondensator,
▪ Gatetreiber,
▪ Stromsensor,
▪ Verstärker,
▪ Ladungspumpe,
▪ Dioden,
▪ Spule sowie
▪ Anschlusselement für Messpunkte.

Die Schaltungsanordnung ist wenigstens zu einem, wenigstens zu zwei oder auch zu mehreren der folgenden Zwecke oder Funktionen vorgesehen:
▪ Anschluss einer Ansteuerplatine,
▪ Temperaturmessung,
▪ Bereitstellen eines Widerstands,
▪ Kelvin-Anschluss eines Mosfets,
▪ Bereitstellen einer Kapazität,
▪ Gatetreiber,
▪ Stromsensor,
▪ Verstärkung,
▪ Ladungspumpe,
▪ Sperrung der intrinsischen Diode eines Mosfets,
▪ Bereitstellung einer Induktivität sowie
▪ Anschluss von Messpunkten.

### Bezugszeichenliste

- 1: Verbindungselement
- 2: drittes Bauelement
- 3: Sensor
- 11: erster Verbindungsbereich
- 12: erstes Bauelement
- 13: zweiter Verbindungsbereich
- 14: zweites Bauelement
- 15: dritter Verbindungsbereich
- 16: Übergangsbereich
- 17, 18: Stücke

- 20, 30: Kontaktierungselement
- 21, 31: erster Kontaktierungsbereich
- 22, 32: zweiter Kontaktierungsbereich
- 23: viertes Bauelement
- 30: zweites Kontaktierungselement
- 33: fünftes Bauelement

- 40, 42: vierter Verbindungsbereich
- 41: sechstes Bauelement
- 51: siebtes Bauelement
- 50, 52: fünfter Verbindungsbereich

## Patentansprüche

1. Schaltungsanordnung, umfassend
- wenigstens ein Bondelement (1), das ein Multifunktionsbügel ist, wobei das Bondelement umfasst:
eine erste Verbindungsfläche (11), zur Ausbildung einer elektrisch und thermisch leitenden Verbindung, mechanischen Kopplung und Fixierung eines Leistungshalbleiter-Bauelements als erstes Bauelement (12) und des Bondelements (1), über die das Bondelement (1) mit dem ersten Bauelement (12) verbunden ist,
eine zweite Verbindungsfläche (13), zur elektrisch und thermisch leitenden Fixierung, Anbindung und Kontaktierung der Verbindungsfläche an einen ersten Schaltungsträger (14) als zweites Bauelement, über die das Bondelement (1) mit dem zweiten Bauelement (14) verbunden ist,
eine dritte Verbindungsfläche (15), zur elektrisch und thermisch leitenden Anbindung und Fixierung eines zweiten Schaltungsträgers als drittes Bauelement (2), über die das Bondelement (1) mit dem dritten Bauelement (2) verbunden ist,
eine vierte Verbindungsfläche (40), zur elektrisch und thermisch leitenden Anbindung und Fixierung eines sechsten Bauelements (41) an das Bondelement (1), über die das Bondelement (1) mit dem sechsten Bauelement (41) verbunden ist, wobei sich die Verbindungsfläche senkrecht nach oben erstreckt und
eine fünfte Verbindungsfläche (50), zur elektrisch und thermisch leitenden Anbindung und Fixierung eines siebten Bauelements (51) an das Bondelement (1), über die die Verbindungsfläche (50), mit dem siebten Bauelement (51) verbunden ist, wobei sich die Verbindungsfläche senkrecht nach oben erstreckt,
wobei zumindest die erste Verbindungsfläche (11), die zweite Verbindungsfläche (13) und die dritte Verbindungsfläche (15) elektrisch und thermisch leitend verbunden sind und das Bondelement (1) elektrisch und thermisch leitend ausgebildet ist, wobei die erste Verbindungsfläche (11) und die zweite Verbindungsfläche (13) auf der Unterseite des Bondelements (1) angeordnet sind und die dritte Verbindungsfläche (15) auf der Oberseite des Bondelements (1) angeordnet ist,
wobei auf dem dritten Bauelement (2) ein Sensor (3) angeordnet ist, insbesondere ein
- ein erstes Kontaktierungselement (20) als erster Kontaktbügel, zur elektrisch und thermisch leitenden Anbindung des dritten Bauelements (2) an ein viertes Bauelement (23), über den das dritte Bauelement (2) mit dem vierten Bauelement (23) verbunden ist, wobei das erste Kontaktierungselement (20) umfasst:
- eine erste Kontaktierungsfläche (21), zur elektrisch und thermisch leitenden Anbindung des dritten Bauelements (2) an das Kontaktierungselement (20), über die das Kontaktierungselement (20) mit dem dritten Bauelement (2) verbunden ist,
- eine zweite Kontaktierungsfläche (22) zur elektrisch und thermisch leitenden Anbindung eines vierten Bauelements (23) an das Kontaktierungselement (20), über die das Kontaktierungselement (20) mit dem vierten Bauelement (23) verbunden ist, und
- ein zweites Kontaktierungselement (30) als zweiter Kontaktbügel, zur elektrisch und thermisch leitenden Anbindung des dritten Bauelements (2) an ein fünftes Bauelement (33), über den das dritte Bauelement (2) mit dem fünften Bauelement (33) verbunden ist, wobei das zweite Kontaktierungselement (30) umfasst:
- eine erste Kontaktierungsfläche (31), zur elektrisch und thermisch leitenden Anbindung des dritten Bauelements (2) an das Kontaktierungselement (30), über die das Kontaktierungselement (30) mit dem dritten Bauelement (2) verbunden ist,
- eine zweite Kontaktierungsfläche (32), zur elektrisch und thermisch leitenden Anbindung eines fünften Bauelements (33) an das Kontaktierungselement (30), über die das Kontaktierungselement (30) mit dem fünften Bauelement (33) verbunden ist.

2. Schaltungsanordnung nach Anspruch 1, wobei die erste Kontaktierungsfläche (21) in einer Ebene und die zweite Kontaktierungsfläche (22) in einer weiteren Ebene angeordnet ist, wobei die Ebene der ersten Kontaktierungsfläche von der weiteren Ebene verschieden, und zu dieser parallel oder mit einem Winkel ist oder wobei die Ebene der ersten Kontaktierungsfläche mit der weiteren Ebene identisch ist.

3. Schaltungsanordnung nach einem der vorhergehenden Ansprüche, wobei zwischen der ersten Kontaktierungsfläche (21) und der zweiten Kontaktierungsfläche (22) ein Übergangsbereich angeordnet ist, wobei der Übergangsbereich insbesondere gerade, L-förmig, stufenartig oder s-förmig verläuft.

4. Schaltungsanordnung nach einem der vorhergehenden Ansprüche, wobei das erste und das zweite Kontaktierungselement (20, 30) aus Metall oder aus einer Metallverbindung bestehen und einstückig oder zweistückig ausgebildet sind.

5. Schaltungsanordnung nach einem der vorhergehenden Ansprüche, wobei das erste und das zweite Kontaktierungselement (20, 30) aus einem flachen, insbesondere rechteckigen Metallteil hergestellt sind und mit einem oder zwei Krümmungsbereichen versehen sind.

6. Schaltungsanordnung nach einem der vorhergehenden Ansprüche, wobei das erste und das zweite Kontaktierungselement (20, 30) horizontal oder vertikal verlaufen oder parallel oder senkrecht zum dritten Verbindungsbereich (15).

7. Schaltungsanordnung nach einem der vorhergehenden Ansprüche, umfassend wenigstens eines, wenigstens zwei oder mehrere der folgenden Bauelemente:
- Anschlusselement für eine Ansteuerplatine,
- Temperaturmesselement,
- Widerstand,
- Kelvin-Anschluss des Mosfets,
- Kondensator,
- Gatetreiber,
- Stromsensor,
- Verstärker,
- Ladungspumpe,
- Dioden,
- Spule sowie
- Anschlusselement für Messpunkte.

8. Schaltungsanordnung nach einem der vorhergehenden Ansprüche, wobei die Anordnung wenigstens zu einem, wenigstens zu zwei oder zu mehreren der folgenden Zwecke oder Funktionen vorgesehen ist:
- Anschluss einer Ansteuerplatine,
- Anschluss eines Bauelements,
- Temperaturmessung,
- Bereitstellen eines Widerstands,
- Kelvin-Anschluss eines Mosfets,
- Bereitstellen einer Kapazität,
- Gatetreiber,
- Stromsensor,
- Verstärkung,
- Ladungspumpe,
- Sperrung der intrinsischen Diode eines Mosfets,
- Bereitstellung einer Induktivität sowie
- Anschluss von Messpunkten.

## Claims

1. Circuit arrangement, comprising
- at least one bonding element (1) which is a multifunctional bracket, the bonding element comprising:
a first connection surface (11) for forming an electrically and thermally conductive connection, mechanical coupling and fixing of a power semiconductor component as a first component (12) and of the bonding element (1), via which the bonding element (1) is connected to the first component (12),
a second connection surface (13), for electrically and thermally conductive fixing, connection and contacting of the connection surface to a first circuit carrier (14) as a second component, via which the bonding element (1) is connected to the second component (14),
a third connection surface (15), for the electrically and thermally conductive connection and fixing of a second circuit carrier as a third component (2), via which the bonding element (1) is connected to the third component (2),
a fourth connection surface (40), for the electrically and thermally conductive connection and fixing of a sixth component (41) to the bonding element (1), via which the bonding element (1) is connected to the sixth component (41), the connection surface extending vertically upwards, and
a fifth connection surface (50) for electrically and thermally conducting connection and fixing of a seventh component (51) to the bonding element (1), via which the connection surface (50) is connected to the seventh component (51), the connection surface extending vertically upwards,
wherein at least the first connection surface (11), the second connection surface (13) and the third connection surface (15) are electrically and thermally conductively connected and the bonding element (1) is electrically and thermally conductively formed, wherein the first connection surface (11) and the second connection surface (13) are arranged on the underside of the bonding element (1) and the third connection surface (15) is arranged on the upper side of the bonding element (1),
wherein a sensor (3) is arranged on the third component (2),
- a first contacting element (20) as a first contact bracket, for electrically and thermally conducting connection of the third component (2) to a fourth component (23), via which the third component (2) is connected to the fourth component (23), wherein the first contacting element (20) comprises
- a first contacting surface (21), for electrically and thermally conducting connection of the third component (2) to the contacting element (20), via which the contacting element (20) is connected to the third component (2),
- a second contacting surface (22) for electrically and thermally conducting connection of a fourth component (23) to the contacting element (20), via which the contacting element (20) is connected to the fourth component (23), and
- a second contacting element (30) as a second contact bracket, for electrically and thermally conducting connection of the third component (2) to a fifth component (33), via which the third component (2) is connected to the fifth component (33), the second contacting element (30) comprising:
- a first contacting surface (31), for electrically and thermally conducting connection of the third component (2) to the contacting element (30), via which the contacting element (30) is connected to the third component (2),
- a second contacting surface (32), for the electrically and thermally conductive connection of a fifth component (33) to the contacting element (30), via which the contacting element (30) is connected to the fifth component (33).

2. Circuit arrangement according to claim 1, wherein the first contacting surface (21) is arranged in a plane and the second contacting surface (22) is arranged in a further plane, wherein the plane of the first contacting surface is different from the further plane and is parallel or angled thereto, or wherein the plane of the first contacting surface is identical to the further plane.

3. Circuit arrangement according to any one of the preceding claims, wherein a transition region is arranged between the first contacting surface (21) and the second contacting surface (22), wherein the transition region extends in particular in a straight, L-shaped, step-like or s-shaped manner.

4. Circuit arrangement according to any one of the preceding claims, wherein the first and the second contacting elements (20, 30) are made of metal or of a metal compound and are formed in one piece or in two pieces.

5. Circuit arrangement according to any one of the preceding claims, wherein the first and the second contacting element (20, 30) are made of a flat, in particular rectangular metal part and are provided with one or two curvature regions.

6. Circuit arrangement according to any one of the preceding claims, wherein the first and second contacting elements (20, 30) extend horizontally or vertically, or parallel or perpendicular to the third connection surface (15).

7. Circuit arrangement according to any one of the preceding claims, comprising at least one, at least two or more of the following components:
- connection element for a control board,
- temperature measuring element,
- resistor,
- Kelvin connection of the MOSFET,
- capacitor,
- gate driver,
- current sensor,
- amplifier,
- charge pump,
- diodes,
- coil and
- connection element for measuring points.

8. Circuit arrangement according to any one of the preceding claims, wherein the arrangement is provided for at least one, at least two or more of the following purposes or functions:
- connection of a control board,
- connection of a component,
- temperature measurement,
- providing a resistance,
- Kelvin connection of a MOSFET,
- providing a capacity,
- gate driver,
- current sensor,
- amplification,
- charge pump,
- inhibition of the intrinsic diode of a MOSFET,
- provision of an inductance and
- connection of measuring points.

## Revendications

1. Circuit comprenant
- au moins un élément de réception (1) qui est un support multifonctionnel, l'élément de réception comprenant:
une première surface de connexion (11) pour former une connexion électriquement et thermiquement conductrice, un couplage mécanique et une fixation d'un composant semi-conducteur de puissance en tant que premier composant (12) et de l'élément de liaison (1), par laquelle l'élément de liaison (1) est relié au premier composant (12),
une deuxième surface de connexion (13) pour la fixation, la connexion et la mise en contact électriquement et thermiquement conductrice de la surface de connexion avec un premier support de circuit (14) en tant que deuxième composant, par l'intermédiaire duquel l'élément de liaison (1) est relié au deuxième composant (14),
une troisième surface de connexion (15) pour la connexion et la fixation électriquement et thermiquement conductrices d'un deuxième support de circuit en tant que troisième composant (2), par l'intermédiaire duquel l'élément de liaison (1) est relié au troisième composant (2),
une quatrième surface de connexion (40) pour la connexion et la fixation électriquement et thermiquement conductrices d'un sixième composant (41) à l'élément de liaison (1), par laquelle l'élément de liaison (1) est connecté au sixième composant (41), la surface de connexion s'étendant verticalement vers le haut, et
une cinquième surface de connexion (50) pour la connexion et la fixation électriquement et thermiquement conductrices d'un septième composant (51) à l'élément de liaison (1), par laquelle la surface de connexion (50) est reliée au septième composant (51), la surface de connexion s'étendant verticalement vers le haut,
dans lequel au moins la première surface de connexion (11), la deuxième surface de connexion (13) et la troisième surface de connexion (15) sont connectées de manière électriquement et thermiquement conductrice et l'élément de liaison (1) est électriquement et thermiquement conducteur, dans lequel la première surface de connexion (11) et la deuxième surface de connexion (13) sont disposées sur le côté inférieur de l'élément de liaison (1) et la troisième surface de connexion (15) est disposée sur le côté supérieur de l'élément de liaison (1),
dans lequel un capteur (3) est disposé sur le troisième composant (2),
- un premier élément de contact (20) en tant que premier support de contact, pour la connexion électriquement et thermiquement conductrice du troisième composant (2) à un quatrième composant (23), par l'intermédiaire duquel le troisième composant (2) est relié au quatrième composant (23), le premier élément de contact (20) comprenant:
- une première surface de contact (21) pour la liaison électriquement et thermiquement conductrice du troisième composant (2) avec l'élément de contact (20), par laquelle l'élément de contact (20) est relié au troisième composant (2),
- une deuxième surface de contact (22) pour la connexion électriquement et thermiquement conductrice d'un quatrième composant (23) à l'élément de contact (20), par laquelle l'élément de contact (20) est connecté au quatrième composant (23), et
- un deuxième élément de contact (30) en tant que deuxième support de contact, pour la connexion électriquement et thermiquement conductrice du troisième composant (2) à un cinquième composant (33), par l'intermédiaire duquel le troisième composant (2) est relié au cinquième composant (33), le deuxième élément de contact (30) comprenant:
- une première surface de contact (31) pour la liaison électriquement et thermiquement conductrice du troisième composant (2) avec l'élément de contact (30), par laquelle l'élément de contact (30) est relié au troisième composant (2),
- une deuxième surface de contact (32) pour la connexion électriquement et thermiquement conductrice d'un cinquième composant (33) à l'élément de contact (30), par laquelle l'élément de contact (30) est connecté au cinquième composant (33).

2. Agencement de circuit selon la revendication 1, dans lequel la première surface de contact (21) est disposée dans un plan et la seconde surface de contact (22) est disposée dans un autre plan, dans lequel le plan de la première surface de contact est différent de l'autre plan et est parallèle ou incliné par rapport à celui-ci, ou dans lequel le plan de la première surface de contact est identique à l'autre plan.

3. Agencement de circuit selon l'une des revendications précédentes, dans lequel une zone de transition est disposée entre la première surface de contact (21) et la deuxième surface de contact (22), la zone de transition s'étendant notamment de manière rectiligne, en forme de L, en forme de gradin ou en forme de S.

4. Agencement de circuit selon l'une des revendications précédentes, dans lequel le premier et le deuxième éléments de contact (20, 30) sont en métal ou en un composé métallique et sont formés en une seule pièce ou en deux pièces.

5. Agencement de circuit selon l'une des revendications précédentes, dans lequel le premier et le deuxième élément de contact (20, 30) sont constitués d'une pièce métallique plate, notamment rectangulaire, et sont pourvus d'une ou deux zones de courbure.

6. Agencement de circuit selon l'une des revendications précédentes, dans lequel les premier et deuxième éléments de contact (20, 30) s'étendent horizontalement ou verticalement, ou parallèlement ou perpendiculairement à la troisième région de connexion (15).

7. Agencement de circuit selon l'une des revendications précédentes, comprenant au moins un, au moins deux ou plusieurs des composants suivants:
- Élément de connexion pour une carte de contrôle,
- Élément de mesure de la température,
- Résistance,
- Connexion Kelvin du mosfet,
- Condensateur,
- Pilote de portail,
- Capteur de courant,
- Amplificateur,
- Pompe de charge,
- Diodes,
- Bobine et
- Élément de connexion pour les points de mesure.

8. Agencement de circuit selon l'une des revendications précédentes, dans lequel l'agencement est prévu pour au moins un, au moins deux ou plusieurs des buts ou fonctions suivants:
- Connexion d'une carte de contrôle,
- Connexion d'un composant,
- Mesure de la température,
- Fournir une résistance,
- Connexion Kelvin d'un mosfet,
- Fournir une capacité,
- Pilote de portail,
- Capteur de courant,
- Renforcement,
- pompe de charge,
- Inhiber la diode intrinsèque d'un mosfet,
- La fourniture d'une inductance et
- Connexion des points de mesure.
